# EUROPÄISCHE PATENTSCHRIFT

(11) **EP 2 116 115 B1**
(45) Veröffentlichungstag und Bekanntmachung des Hinweises auf die Patenterteilung: **29.12.2010**
(21) Anmeldenummer: 07702421.4
(22) Anmeldetag: 02.02.2007
(51) Int. Cl.: H05K 3/32, H05K 3/40, H01R 12/32, H01R 13/10, H01L 21/48, H01L 23/055, H01L 23/16, H01L 23/433, H01L 23/498

(54) **VERFAHREN ZUM HERSTELLEN EINER STECKBAREN ANSCHLUSSKONTAKTIERUNG AUF EINEM HALBLEITERMODUL UND MIT DIESEM VERFAHREN HERGESTELLETES HALBLEITERMODUL**
METHOD FOR THE PRODUCTION OF A PLUGGABLE CONNECTION CONTACT ON A SEMICONDUCTOR MODULE AND SEMICONDUCTOR MODULE PRODUCED BY THIS METHOD
PROCÉDÉ DE FABRICATION D'UN CONTACT DE RACCORDEMENT ENFICHABLE SUR UN MODULE DE SEMI-CONDUCTEUR ET MODULE DE SEMI-CONDUCTEUR FABRIQUE SELON CE PROCÉDÉ

(43) Veröffentlichungstag der Anmeldung: 11.11.2009
(73) Patentinhaber: Siemens Aktiengesellschaft, 80333 München (DE)
(72) Erfinder: KREUTZER, Rainer, 92637 Weiden (DE); WÖLLMER, Heinz, 92260 Ammerthal (DE)
(86) Internationale Anmeldenummer: PCT/DE2007/000191
(87) Internationale Veröffentlichungsnummer: WO 2008/092414

(56) Entgegenhaltungen:
- DE-A1- 4 420 525
- DE-A1- 10 008 572
- GB-A- 2 310 088
- US-A1- 2002 105 075

## Beschreibung

Die Erfindung bezieht sich auf ein Verfahren zum Herstellen einer steckbaren Anschlusskontaktierung auf einem Halbleitermodul. Die Erfindung bezieht sich außerdem auf ein mit diesem Verfahren hergestelltes Halbleitermodul.

Elektronische Geräte sind in der Regel modular, d.h. aus einer Mehrzahl von Modulen oder Baugruppen aufgebaut. Jedes Modul (Halbleitermodul) bzw. jede Baugruppe enthält ein oder mehrere auf einem gemeinsamen Träger angeordnete Halbleiterbauelemente. Vorteil eines solchen modularen Aufbaus ist neben einer höheren Flexibilität auch ein erleichterter Austausch eines gesamten Halbleitermoduls im Falle eines Defektes. Die Verbindung eines solchen Halbleitermoduls mit anderen Baugruppen des elektronischen Gerätes erfolgt in der Regel über eine steckbare Anschlusskontaktierung mit in der Regel mehreren Kontaktelementen, die jeweils stoffschlüssig, d.h. fest mit einer auf dem Träger angeordneten Kontaktfläche verbunden sind.

Aus der DE 100 08 572 A1 ist es bekannt, als Kontaktelemente für die Anschlusskontaktierung auf den Träger Kontakthülsen aufzulöten, in die zur elektrischen Kontaktierung ein Kontaktstück eingeführt werden kann. Alternativ hierzu wird in der DE 101 03 084 A1 vorgeschlagen, auf dem Träger eines Halbleiterbauelementes eine L-förmige Kontaktlasche anzuordnen, deren kurzer Schenkel mit einer metallischen Kontaktfläche des Trägers durch ein Laserschweißverfahren verbunden wird.

**Aus der** DE 44 20 525 A1 **ist ein Verbindungssystem zum Kontaktieren von Bauelementen mit Finepitch-Rasterung auf Leiterplatten bekannt. Dieses Verbindungssystem weist einen Kontaktstift, sowie eine Kontakthülse auf.**

Der Erfindung liegt nun die Aufgabe zu Grunde, ein Verfahren zum Herstellen einer steckbaren Anschlusskontaktierung auf einem Halbleitermodul anzugeben, mit dem es möglich ist, auch unter räumlich beengten Verhältnissen Kontaktelemente mit dem Träger mechanisch und elektrisch zu verbinden, und bei dem die Gefahr einer Beschädigung der Halbleiterbauelemente beim Herstellen der Verbindung weitgehend reduziert ist. Außerdem liegt der Erfindung die Aufgabe zu Grunde, ein mit diesem Verfahren hergestelltes Halbleitermodul anzugeben.

Hinsichtlich des Verfahrens wird die Aufgabe gemäß der Erfindung gelöst mit einem Verfahren mit den Merkmalen des Patentanspruches 1. Gemäß diesen Merkmalen wird auf eine auf einem zumindest ein Halbleiterbauelement enthaltenden Träger befindliche metallische Kontaktfläche eine Kontakthülse aufgesetzt und mit einem Laserschweißverfahren mit der Kontaktfläche stoffschlüssig verbunden. Durch die Verwendung einer Kontakthülse, in die zur elektrischen Kontaktierung ein Kontaktstift eingeführt werden kann, ist bei geringem Platzbedarf eine sichere elektrische Anschlusskontaktierung gewährleistet. Da außerdem die Kontakthülse mit einem Laserschweißverfahren stoffschlüssig mit dem Träger verbunden wird, ist der Wärmeeintrag beim Herstellen der Verbindung gegenüber einem Lötverfahren deutlich verringert, so dass thermische Schädigungen der auf dem Träger befindlichen Halbleiterbauelemente weitgehend vermieden sind.

Wenn die Kontakthülse mit einer Mehrzahl von Schweißpunkten mit der Kontaktfläche verschweißt wird, ist bei ausreichender Festigkeit der Verbindung der Wärmeeintrag zusätzlich reduziert.

In einer vorteilhaften Ausgestaltung des Verfahrens wird die Kontakthülse durch eine Überlappschweißung mit der Kontaktfläche verbunden. Dadurch ist bei einfacher Prozessführung eine besonders hohe mechanische Stabilität gewährleistet.

Vorzugsweise wird eine Kontakthülse verwendet, die an einer ihrer Stirnseiten einen Steg aufweist, mit dem sie auf die Kontaktfläche aufgesetzt und der mit der Kontakthülse verschweißt wird. Dies ermöglicht eine besonders feste Verbindung zwischen Kontakthülse und Kontaktfläche.

In einer besonders bevorzugten Ausgestaltung des Verfahrens wird eine Kontakthülse verwendet, bei der der mit der Kontaktfläche verschweißte Steg innerhalb der Kontakthülse angeordnet ist. Durch diese Maßnahme erfolgt das Laserschweißen innerhalb der Kontakthülse, die dann zugleich als zusätzliche Abschirmung dient, so dass die an der Schweißzone reflektierte Laserstrahlung nicht auf benachbarte Halbleiterbauelemente treffen kann. Dadurch ist es möglich, die Halbleiterbauelemente sehr nahe an den Anschlusskontakten zu platzieren, so dass die Baugröße des Halbleitermoduls verringert ist.

Alternativ zur Verwendung einer Kontakthülse mit einem innen umlaufenden Bund ist es auch möglich, eine Kontakthülse zu verwenden, die an einer ihrer Stirnseiten mit einem Boden verschlossen ist, mit dem sie auf die Kontaktfläche aufgesetzt wird und der mit der Kontaktfläche durch eine Überlappschweißung verbunden wird.

Hinsichtlich des Halbleitermoduls wird die Aufgabe gemäß der Erfindung gelöst mit einem Halbleitermodul mit dem Merkmalen des Patentanspruches 7. Vorteilhafte Ausgestaltungen des Halbleitermoduls sind in den Unteransprüchen 8 bis 12 angegeben. Die Vorteile der in diesen Patentansprüchen angegebenen Halbleitermodule entsprechen sinngemäß den zu den jeweils zugehörigen Verfahrensansprüchen angegebenen Vorteilen.

Eine besonders sichere elektrische Verbindung zwischen einer Kontakthülse und einem in diese eingeführten Kontaktstift wird ermöglicht, wenn dieser einen quer zu seiner Längsachse in zumindest einer Richtung elastisch verformbaren Bereich aufweist, der im eingeführten Zustand federnd an der Innenoberfläche der Kontakthülse anliegt.

Zur weiteren Erläuterung der Erfindung wird auf die Ausführungsbeispiele der Zeichnungen verwiesen. Es zeigen:
- Figur 1: ein Halbleitermodul gemäß der Erfindung in einer schematischen Prinzipdarstellung,
- Figuren 2 bis 4: jeweils alternative Ausgestaltungen einer auf einer Kontaktfläche aufgeschweißten Kontakthülse jeweils in einer schematisch- perspektivischen Darstellung und einer Schnittdarstellung.
- Figuren 5 und 6: jeweils alternative Ausführungsformen eines zum Einführen in eine Kontakthülse vorgese- henen Kontaktstiftes.

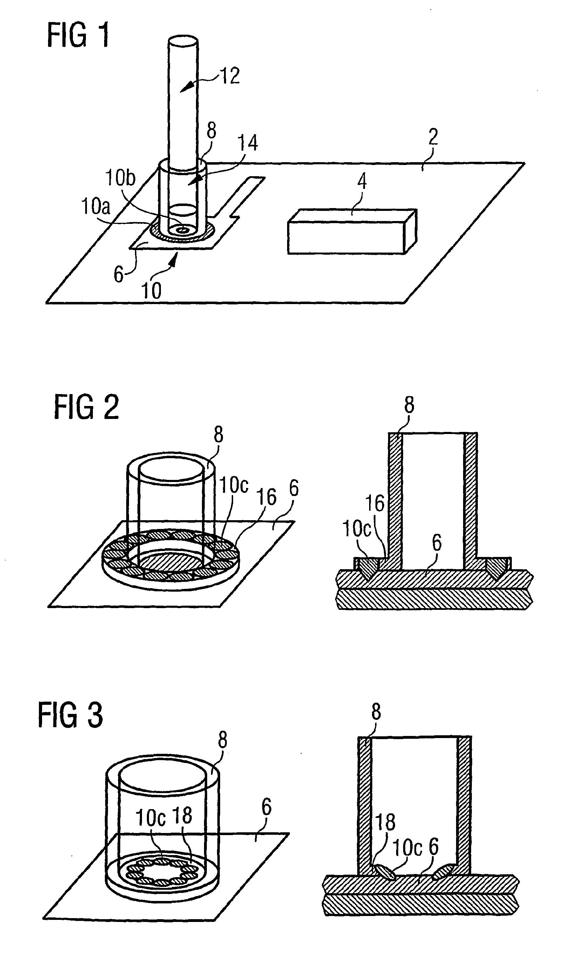

Gemäß Figur 1 umfasst ein Halbleitermodul wenigstens ein auf einem Träger 2 angeordnetes Halbleiterbauelement 4. Der Träger 2 weist auf einer seiner Oberflächen in der Regel eine Mehrzahl von metallischen Kontaktflächen 6 auf, von denen in der Figur zur Vereinfachung nur eine einzige dargestellt ist. Auf die Kontaktfläche 6 ist mit einer ihrer Stirnseiten eine Kontakthülse 8 aufgesetzt, die mit der Kontaktfläche 6 in Schweißzonen 10 verschweißt ist. Im Ausführungsbeispiel der Figur 1 ist eine ringförmig die Kontakthülse 8 umgebende Schweißzone 10a sowie eine innerhalb der Kontakthülse 8 angeordnete Schweißzone 10b veranschaulicht.

In die Kontakthülse 8 ist ein Kontaktstift 12 eingeführt, der mit seiner Kontaktzone 14 am Innenumfang der Kontakthülse 8 anliegt.

Im Ausführungsbeispiel gemäß Figur 2 ist eine hohlzylindrische Kontakthülse 8 vorgesehen, die an einer ihrer Stirnseiten einen außen ringförmig umlaufenden Bund oder Steg 16 aufweist, mit dem sie auf der Kontaktfläche 6 aufsitzt. Der Steg 16 ist mit einer Mehrzahl von Schweißpunkten 10c durch eine Überlappschweißung mit der Kontaktfläche 6 verschweißt.

In der alternativen Ausführung gemäß Figur 3 weist die Kontakthülse 8 an einer ihrer Stirnseiten einen innerhalb der Kontakthülse 8 umlaufenden Steg 18 auf, der ebenfalls über eine Vielzahl von Schweißpunkten 10c mit der Kontaktfläche 6 verschweißt ist.

Anstelle eines in den Fig. 2 und 3 dargestellten umlaufenden Bundes oder Steges 16, 18 können auch eine Mehrzahl von einzelnen, in Umfangsrichtung voneinander beabstandeten, nach außen oder innen gerichteten Stegen oder Laschen vorgesehen sein, die jeweils mit einem Schweißpunkt 10c mit der Kontaktfläche 6 verschweißt sind.

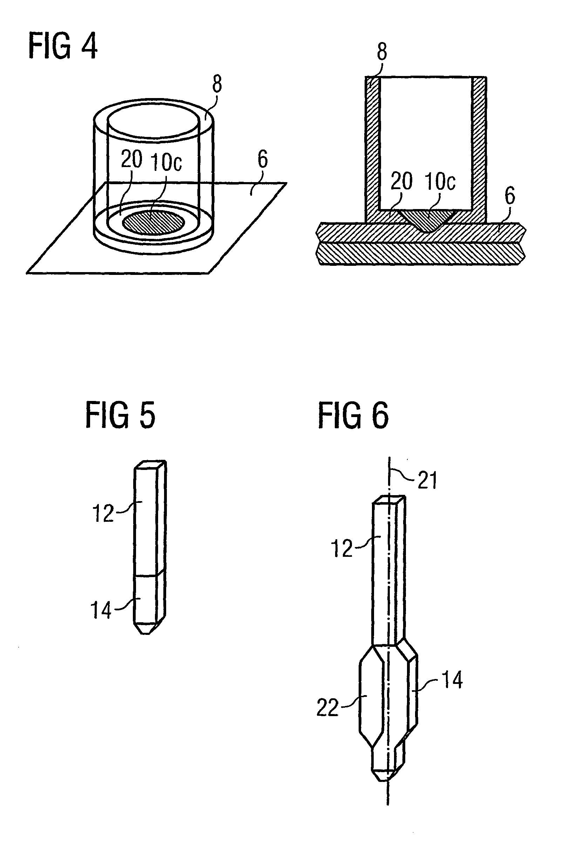

Im Ausführungsbeispiel gemäß Figur 4 ist die Kontakthülse 8 an einer ihrer Stirnseiten mit einem Boden 20 verschlossen. Dieser Boden ist ebenfalls mit einer Überlappschweißung, im vorliegenden Fall mit einem einzigen Schweißpunkt 10c mit der Kontaktfläche 6 verschweißt.

Die Erfindung ist nicht auf die in den Figuren 1 bis 4 dargestellte zylindrische Form der Kontakthülse 8 beschränkt. Grundsätzlich kann die Kontakthülse auch eine andere geometrische Form aufweisen. Anstelle einer kreisförmigen Innenquerschnittsfläche kann die Kontakthülse beispielsweise auch eine quadratische Innenquerschnittsfläche aufweisen, in die dann an Stelle eines zylindrischen Kontaktstiftes 12 ein Kontaktstift 12 mit quadratischer Querschnittsfläche gemäß Fig. 5 eingeführt werden kann.

Im Ausführungsbeispiels gemäß Figur 6 weist der Kontaktstift 12 in seiner Kontaktzone 14 einen quer zu seiner Längsachse 21 elastisch verformbaren Bereich 22 auf, der beim Einführen des Kontaktstiftes 12 in die Kontakthülse zusammengedrückt wird und eine kraftschlüssige Verbindung mit dem Innenumfang der Kontakthülse und damit eine besonders stabile und sichere Kontaktierung herstellt. Im Beispiel ist der Bereich 22 durch ein Federelement gebildet, das in einer Richtung quer zur Längsachse 21 verformbar ist. Grundsätzlich ist es auch möglich in der Kontaktzone 14 einen in mehrere Radialrichtungen verformbaren Bereich anzuordnen.

## Patentansprüche

1. Verfahren zum Herstellen einer steckbaren Anschlusskontaktierung auf einem Halbleitermodul mit zumindest einem auf einem Träger (2) angeordneten Halbleiterbauelement (4), bei dem auf eine auf dem Träger (2) befindliche metallische Kontaktfläche (6) eine Kontakthülse (8) aufgesetzt **wird**, **dadurch gekennzeichnet , dass die Kontakthülse** (8) mit einem Laserschweißverfahren mit der Kontaktfläche (6) stoffschlüssig verbunden wird.

2. Verfahren nach Anspruch 1, bei dem die Kontakthülse (8) mit einer Mehrzahl von Schweißpunkten (10c) mit der Kontaktfläche (6) verschweißt wird.

3. Verfahren nach Anspruch 1 oder 2, bei dem die Kontakthülse (8) durch eine Überlappschweißung mit der Kontaktfläche (6) verbunden wird.

4. Verfahren nach einem der vorhergehenden Ansprüche, bei dem eine Kontakthülse (8) verwendet wird, die an einer ihrer Stirnseiten mit einem Steg (16, 18) versehen ist, mit dem sie auf die Kontaktfläche (6) aufgesetzt wird, und der mit der Kontaktfläche (6) verschweißt wird.

5. Verfahren nach Anspruch 4, bei dem der Steg (16) innerhalb der Kontakthülse (8) angeordnet ist.

6. Verfahren nach einem der Ansprüche 1 bis 3, bei dem eine Kontakthülse (8) verwendet wird, die an einer ihrer Stirnseiten mit einem Boden (20) verschlossen ist, mit dem sie auf die Kontaktfläche (6) aufgesetzt wird, und der mit der Kontaktfläche (6) verschweißt wird.

7. Halbleitermodul mit zumindest einem auf einem Träger (2) angeordneten Halbleiterbauelement (4), und mit einer zur steckbaren Anschlusskontaktierung dienenden Kontakthülse (8), **dadurch gekennzeichnet , dass die Kontakthülse (8)** mit einer auf dem Träger (2) befindlichen metallischen Kontaktfläche (6) mit einer Laserschweißverbindung stoffschlüssig verbunden ist.

8. Halbleitermodul nach Anspruch 7, bei dem die Kontakthülse (8) mit einer Mehrzahl von Schweißpunkten (16c) mit der Kontaktfläche (6) verschweißt ist.

9. Halbleitermodul nach Anspruch 7 oder 8, bei dem die Kontakthülse (8) durch eine Überlappschweißung mit der Kontaktfläche (6) verbunden ist.

10. Halbleitermodul nach einem der Ansprüche 7 bis 9, bei dem die Kontakthülse (8) an einer ihrer Stirnseiten einen Steg (16, 18) aufweist, mit dem sie auf der Kontaktfläche (6) aufsitzt, und der mit der Kontaktfläche (6) verschweißt ist.

11. Halbleitermodul nach Anspruch 10, bei dem der Steg (18) innerhalb der Kontakthülse (8) angeordnet ist.

12. Halbleitermodul nach einem der Ansprüche 7 bis 9, bei dem die Kontakthülse (8) an einer ihrer Stirnseiten mit einem Boden (20) verschlossen ist, mit dem sie auf der Kontaktfläche (6) aufsitzt, und der mit der Kontaktfläche (6) verschweißt ist.

## Claims

1. Method for producing a pluggable connection contact on a semiconductor module comprising at least one semiconductor component (4) arranged on a carrier (2), in which a contact sleeve (8) is placed onto a metallic contact area (6) situated on the carrier (2) **characterized in that** the contact sleeve (8) is cohesively connected to the contact area (6) by a laser welding method.

2. Method according to Claim 1, in which the contact sleeve (8) is welded to the contact area (6) with a plurality of welding spots (10c).

3. Method according to Claim 1 or 2, in which the contact sleeve (8) is connected to the contact area (6) by lap welding.

4. Method according to any of the preceding claims, in which a contact sleeve (8) is used which, at one of its end sides, is provided with a web (16, 18) by which it is placed onto the contact area (6) and which is welded to the contact area (6).

5. Method according to Claim 4, in which the web (16) is arranged within the contact sleeve (8).

6. Method according to any of Claims 1 to 3, in which a contact sleeve (8) is used which, at one of its end sides, is closed with a base (20) by which it is placed onto the contact area (6) and which is welded to the contact area (6).

7. Semiconductor module comprising at least one semiconductor component (4) arranged on a carrier (2) and comprising a contact sleeve (8) serving for pluggable connection contact-making, **characterized in that** the contact sleeve (8) is cohesively connected to a metallic contact area (6) situated on the carrier (2) by means of a laser welding connection.

8. Semiconductor module according to Claim 7, in which the contact sleeve (8) is welded to the contact area (6) with a plurality of welding spots (10c).

9. Semiconductor module according to Claim 7 or 8, in which the contact sleeve (8) is connected to the contact area (6) by lap welding.

10. Semiconductor module according to any of Claims 7 to 9, in which the contact sleeve (8), at one of its end sides, has a web (16, 18) by which it is seated on the contact area (6) and which is welded to the contact area (6).

11. Semiconductor module according to Claim 10, in which the web (18) is arranged within the contact sleeve (8).

12. Semiconductor module according to any of Claims 7 to 9, in which the contact sleeve (8) at one of its end sides, is closed with a base (20) by which it is seated on the contact area (6) and which is welded to the contact area (6).

## Revendications

1. Procédé de production d'un contact de raccordement enfichable sur un module à semi-conducteur comprenant au moins un composant ( 4 ) à semi-conducteur disposé sur un support ( 2 ), dans lequel on met une douille ( 8 ) de contact sur une surface ( 6 ) métallique de contact se trouvant sur le support ( 2 ), **caractérisé en ce qu'**on relie, à complémentarité de matière, la douille ( 8 ) de contact à la surface ( 6 ) de contact par un procédé de soudage au laser.

2. Procédé suivant la revendication 1, dans lequel on soude la douille ( 8 ) de contact à la surface ( 6 ) de contact par une multiplicité de points ( 10c ) de soudure.

3. Procédé suivant la revendication 1 ou 2, dans lequel on relie la douille ( 8 ) de contact à la surface ( 6 ) de contact par une soudure à recouvrement.

4. Procédé suivant l'une des revendications précédentes, dans lequel on utilise une douille ( 8 ) de contact, qui est munie sur l'un de ses côtés frontaux d'un rebord ( 16, 18 ), par lequel elle est mise sur la surface ( 6 ) de contact et qui est soudé à la surface ( 6 ) de contact.

5. Procédé suivant la revendication 4, dans lequel le rebord ( 16 ) est disposé à l'intérieur de la douille ( 8 ) de contact.

6. Procédé suivant l'une des revendications 1 à 3, dans lequel on utilise une douille ( 8 ) de contact qui est fermée sur l'un de ses côtés frontaux par un fond ( 20 ) par lequel elle est mise sur la surface ( 6 ) de contact et qui est soudé à la surface ( 6 ) de contact.

7. Module à semi-conducteur comprenant au moins un composant ( 4 ) à semi-conducteur sur un support ( 2 ) et ayant une douille ( 8 ) de contact servant à la mise en contact de connexion enfichable, **caractérisé en ce que** qu'on relie, à complémentarité de matière, la douille ( 8 ) de contact à la surface ( 6 ) de contact par un procédé de soudage au laser.

8. Module à semi-conducteur suivant la revendication 7, dans lequel la douille ( 8 ) de contact est soudée à la surface ( 6 ) de contact par une multiplicité de points ( 16c ) de soudure.

9. Module à semi-conducteur suivant la revendication 7 ou 8, dans lequel la douille ( 8 ) de contact est reliée à la surface ( 6 ) de contact par une soudure à recouvrement.

10. Module à semi-conducteur suivant l'une des revendications 7 à 9, dans lequel la douille ( 8 ) de contact a sur l'un de ses côtés frontaux un rebord ( 16, 18 ) par lequel elle est appliquée sur la surface ( 6 ) de contact et qui est soudé à la surface ( 6 ) de contact.

11. Module à semi-conducteur suivant la revendication 10, **caractérisé en ce que** le rebord ( 18 ) est disposé à l'intérieur de la douille ( 8 ) de contact.

12. Module à semi-conducteur suivant l'une des revendications 7 à 9, dans lequel la douille ( 8 ) de contact est fermée sur l'un de ses côtés frontaux par un fond ( 20 ) par lequel elle s'applique la surface ( 6 ) de contact et qui est soudé à la surface ( 6 ) de contact.
